# EUROPEAN PATENT APPLICATION

(11) **EP 4 716 413 A1**
(43) Date of publication of application: **25.03.2026**
(21) Application number: 25201324.8
(22) Date of filing: 10.09.2025
(51) Int. Cl.: H10D 89/60, H02H 9/04

(54) **PROTECTION ELECTRONIC DEVICE FOR THE PREVENTION OF DAMAGES INDUCED BY PLASMA-ASSISTED PROCESSES, AND MANUFACTURING METHOD THEREOF**

(30) Priority: 20.09.2024 IT 202400021052
(71) Applicant: STMicroelectronics International N.V., 1228 Plan-les-Ouates, Geneva (CH)
(72) Inventor: CARACE, Fausto, 20900 Monza (IT); MILITELLO, Simone, 20062 Cassano d'Adda (MI) (IT)
(74) Representative: Studio Torta S.p.A.

(57) **Abstract**

Electronic device (100), comprising a circuit module (6) and a protection module (50; 51). The circuit module (6) comprises a P-N junction (102) between a reference terminal (GND) and an electrical node (104), and a plurality of metal connection lines (20) coupled to the electrical node (104) and adapted to be charged due to antenna effect. The protection module (50) comprises an HV transistor (112) and a first capacitor (108). The capacitor (108) is connected between the electrical node (104) and the HV transistor (112) and is configured to turn on the HV transistor (112) when the electrical node (104) charges positively due to the antenna effect. The circuit module (6) is thus maintained at a potential that does not damage the electronic device (100).

## Description

### Technical Field

The present invention relates to an electronic device and to a manufacturing method thereof, in particular to a protection device, for the prevention of plasma-induced damages due to the charging by antenna effect of metal layers that inject positive charges into underlying doped regions, during the manufacturing processes.

### State of the Art

In the technologies used for the manufacturing of VLSI (Very Large Scale Integration) IC (Integrated Circuit) the formation of metal lines on a semiconductor substrate, in particular for the formation of metal interconnects, requires numerous plasma-assisted process steps. Such process steps include, for example: plasma-assisted deposition steps such as physical vapor depositions (e.g. of "sputtering" type), chemical vapor depositions (e.g. of "Plasma Enhanced Chemical Vapor Deposition - PECVD" type) and plasma-assisted etching steps such as reactive ion etchings (e.g. "Reactive Ion Etching - RIE").

These plasma-assisted process steps cause the injection of significant amounts of charge into doped regions within the semiconductor substrate and connected to metal areas having large dimensions, such as for example metal interconnection lines. The metal areas act in fact as charge collectors during these process steps and transfer the collected charges to the aforementioned doped regions. This effect is known as the "antenna effect".

Integrated circuits for smart power management ("Smart Power" integrated circuits) are known in the art. In Smart Power, but also Digital and Imaging integrated circuits, buried regions doped with N-type conductivity (called "Deep N-WELL" or "DNW"), extended in depth into the substrate, are used to insulate analog and/or digital circuit blocks from the substrate to protect them from noise and possible parasitic currents injected into the substrate by power stages. A disadvantage resulting from the use of DNWs is a less efficient discharge, towards a ground terminal through the substrate, of the charges accumulated during the plasma processes. This may lead the circuit blocks insulated by the DNWs to voltages high enough to be damaging, in particular to gate oxides. For example, if a MOS transistor has a body terminal connected or coupled to a ground terminal and a gate terminal connected or coupled to a circuit block insulated by a DNW that charges during the plasma process, the potential difference between the body terminal and the gate terminal of the MOS transistor may lead to the breakdown of the gate oxide of the same MOS transistor. A similar breakdown mechanism of the gate oxide of the MOS transistor may occur in case the body terminal is connected or belongs to a circuit block insulated by a DNW that charges during a plasma process, and the gate terminal is connected or coupled to a ground terminal.

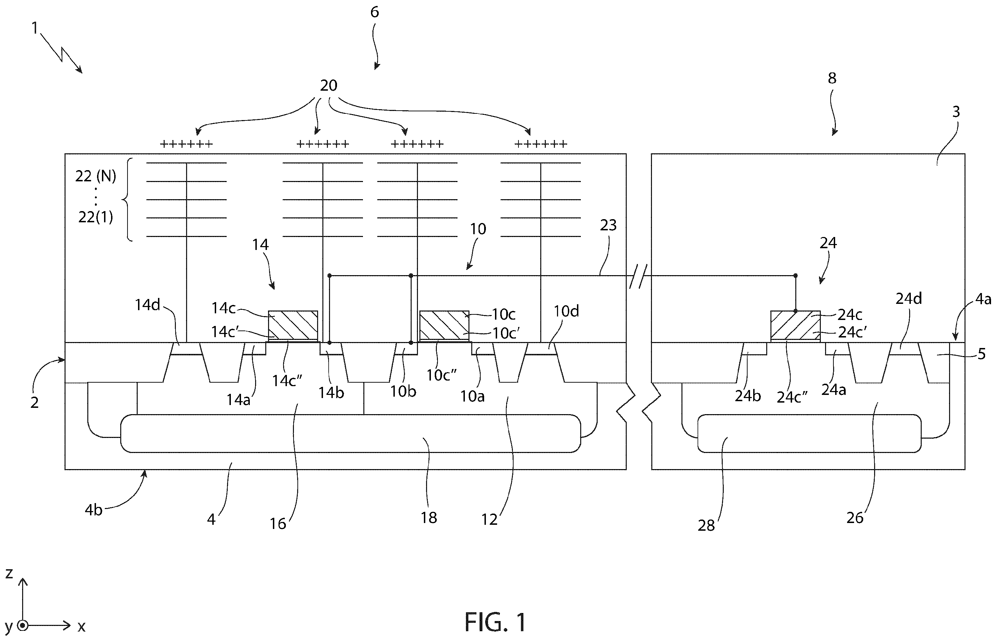

Figure 1 schematically illustrates a part of an integrated circuit 1 of a type known to the Applicant, in a triaxial system of axes x, y, z orthogonal to each other, in a lateral sectional view on the xz plane.

The integrated circuit 1 comprises a solid body 2, which in turn includes: a substrate 4 of semiconductor material such as for example silicon (Si), or silicon carbide (SiC), or gallium nitride (GaN); a patterned oxide layer 5 that extends at a first face 4a of the substrate 4, and that includes openings through which portions of the first face 4a of the substrate 4 are exposed; and a dielectric layer 3 that extends on the patterned oxide layer 5, in direct contact with the patterned oxide layer 5 and with the exposed portions of the first face 4a of the substrate 4. The substrate 4 has, for example, a P-type electrical conductivity. In general, the substrate 4 may comprise one or more structural layers of semiconductor material, for example of the same material indicated above for the substrate 4; such one or more structural layers are, for example, grown epitaxially.

The integrated circuit 1 further comprises a first circuit block 6 that extends at least in part into the substrate 4 and at least in part into the dielectric layer 3, and a second circuit block 8 that extends at least in part into the substrate 4 and at least in part into the dielectric layer 3, laterally and at a distance from the first circuit block 6 along the x axis.

The first circuit block 6 includes a first P-type MOS transistor ("P-MOS") 10 in a first N-type doped region ("first N-WELL") 12 of the substrate 4 and an N-type MOS transistor ("N-MOS") 14 in a P-type doped region ("P-WELL") 16. The P-WELL region 16 is completely surrounded, in view on the XY plane, by the first N-WELL 12 and faces the first face 4a of the substrate 4. The first circuit block 6 also includes a first N-type doped buried region ("first Deep N-WELL" or "first DNW") 18 that extends buried into the substrate 4 in part within the first N-WELL 12 and the P-WELL 16 and in part in the portion of the substrate 4 comprised between the N-WELL 12 / P-WELL 16 and a second face 4b of the substrate 4 opposite, along the Z axis, to the first face 4a. The first DNW 18 is thus in direct electrical contact with the first N-WELL 12 and with the P-WELL 16.

The first circuit block 6 also includes four metal interconnects 20 that extend into the dielectric layer 3 and in electrical contact with a respective doped region between the first N-WELL 12 and the P-WELL 16 at the first face 4a of the substrate 4.

The metal interconnects 20 are formed by multiple metal layers 22(1)-22(N) superimposed along the z axis and having portions of dielectric layer 3 interposed therebetween; through vias extend into the portions of dielectric layer 3 between the metal layers 22(1)-22(N), to electrically connect the metal layers 22(1)-22(N) to each other and to the substrate 4. The number N of metal layers is comprised, for example, in the range 2 - 21 and is, for example, equal to 6.

The second circuit block 8 includes a second P-type MOS transistor ("second P-MOS transistor") 24 in a second N-type doped region ("second N-WELL") 26 of the substrate 4 and a second N-type doped buried region ("second Deep N-WELL" or "second DNW") 28. The second DNW 28 extends buried in the substrate 4 in part within the second N-WELL 26 and in part within the portion of the substrate 4 comprised between the second N-WELL 26 and the second face 4b of the substrate 4. The second DNW 28 is thus in electrical contact with the second N-WELL 26.

At the interface between the first N-WELL 12 / first DNW 18 and the substrate 4 a P-N junction is formed which, when reversely biased, electrically insulates the first circuit block 6 from the substrate 4. Similarly, at the interface between the second N-WELL 26 / second DNW 28 and the substrate 4, a respective P-N junction is formed which, when reversely biased, electrically insulates the first circuit block 6 from the substrate **4.**

The first P-MOS transistor 10, the N-MOS transistor 14, and the second P-MOS transistor 24 include in a known manner respective source terminals 10a, 14a, 24a, respective drain terminals 10b, 14b, 24b, respective gate terminals 10c, 14c, 24c, and respective body terminals 10d, 14d 24d. The gate terminals 10c, 14c, 24c include respective conductive portions 10c', 14c' and 24c' and respective gate dielectrics 10c", 14c" and 24c''.

In the integrated circuit 1 the gate terminal 24c of the second P-MOS transistor 24 is electrically connected to the drain terminal 10b of the first P-MOS transistor 10 and to the drain terminal 14b of the N-MOS transistor 14 through a connection 23 provided in a manner known per se (shown only schematically in Figure 1). For example, in a manner not illustrated in Figure 1, the connection 23 is formed in the first metal layer 22(1).

During the manufacture of the metal interconnects 20, in plasma-process steps successive to the manufacture of the first metal layer 22(1), the progressively formed portions of metal interconnects 20 act as collectors of positive charges. The positive charges are transferred from the plasma to the metal interconnects 20, and from these are injected into the first circuit block 6. The first DNW 18, by insulating the first circuit block 6 from the substrate 4, prevents the dispersion of the accumulated positive charges towards the substrate 4 and thus towards a ground terminal GND connected to the substrate 4. The consequent accumulation of positive charges within the first circuit block 6 results in an increase in the potential difference between the first circuit block 6 and the substrate 4.

In the integrated circuit 1, the second N-WELL 26 is directly electrically connected to metal interconnects 20 of very small area (not shown in the Figure), such as not to inject a significant charge. Consequently, the second N-WELL 26, and thus the body of the second P-MOS transistor 24, remain substantially at the same electrical potential as the substrate 4 and thus close to the ground potential GND. At the same time, the gate terminal 24c of the second P-MOS transistor 24 is connected to the drain terminals 10b, 14b, and is thus at the electrical potential of the first circuit block 6. If the difference in electrical potential between the gate terminal 24c and the body of the second P-MOS transistor 24 exceeds a breakdown threshold of the gate dielectric 24c", the gate dielectric 24c" experiences electrical breakdown, causing the failure of the entire integrated circuit 1.

The breakdown mechanism described above may occur during plasma-assisted processes whenever a device located within a first circuit block (here, block 8) has a gate terminal driven by a device located in a second circuit block (here, block 6), and one of the first circuit block and the second circuit block has metal structures (here, structures 20) that may act as charge collectors, both circuit blocks being insulated from the substrate by respective Deep N-WELLs.

A known technique to protect the gate dielectric 24c" consists in connecting a protection diode in parallel between the gate terminal 24c and the body of the transistor 24. The charges accumulated in the first circuit block 6 are discharged into the body of the transistor 24 through a reverse (or forward) current of the protection diode. However, depending on the process parameters, the current of the protection diode may not be sufficient to effectively discharge the accumulated charges, thus not providing suitable protection. Furthermore, the protection diode may introduce noise during the operation of the device, reducing its performances.

Patent document US2024/274597A1 describes a circuit comprising a substrate with p-well and n-well regions that house n-type and p-type MOSFET transistors, respectively. Conductive connections connect the drain/source terminals to the wells and between the transistors, while other connections connect the gates of the protection transistors to a control circuit. The aim is to ensure the integration and functional protection of the components in the circuit.

Patent document US2001/026970A1 describes a protection device, active during the manufacture of a semiconductor chip, which includes a protection transistor and an antenna that controls its operation. During normal use of the chip, the transistor can be deactivated via a metal line or a reverse-biased diode with a capacitor.

There is therefore a need to provide an electronic device and a manufacturing method thereof, such as to overcome the drawbacks of the prior art.

### Summary

The present invention relates to an electronic device and a manufacturing method thereof, as defined in the attached claims.

### Brief Description of the Drawings

For a better understanding of the present invention, some embodiments thereof are now described, purely by way of non-limiting example, with reference to the attached drawings, wherein:
- Figure 1 schematically illustrates a portion of an integrated circuit of a type known to the Applicant;
- Figure 2A illustrates a circuit diagram of a protection circuit of an integrated circuit according to one embodiment of the present invention and during a step of the manufacturing process;
- Figure 2B illustrates a circuit diagram of the protection circuit of Figure 2A at the end of the manufacturing process;
- Figure 2C illustrates a circuit diagram of a further implementation of a branch of the protection circuit of Figure 2A;
- Figure 2D illustrates a circuit diagram of a further implementation of the same branch of the protection circuit of Figure 2A illustrated in Figure 2C;
- Figure 3 schematically illustrates a portion of the integrated circuit including the protection circuit of Figure 2A;
- Figure 4A illustrates the protection circuit of Figure 2A, in top-plan view;
- Figure 4B schematically illustrates an implementation of a branch of the protection circuit of Figure 2A, in a lateral sectional view along a scribe line I-I of Figure 4A;
- Figure 4C schematically illustrates an implementation of a further branch of the protection circuit of Figure 2A, in a lateral sectional view along a scribe line II-II of Figure 4A;
- Figure 5A schematically illustrates the protection circuit of Figure 2B, in a top-plan view;
- Figure 5B schematically illustrates the branch of Figure 4C after the formation of a last level of metal interconnect, in a lateral sectional view along a scribe line III-III of Figure 5A;
- Figure 6A schematically illustrates one embodiment of a capacitor of the protection circuit of Figures 2A and 2B, in a lateral sectional view;
- Figure 6B schematically illustrates a further embodiment of a capacitor of the protection circuit of Figures 2A and 2B, in a top-plan view;
- Figure 7 schematically illustrates a portion of an integrated circuit including a protection circuit according to a further embodiment of the present invention;
- Figures 8A-8F illustrate manufacturing steps of the portion of the protection circuit illustrated in Figure 5C.

### Description of Embodiments

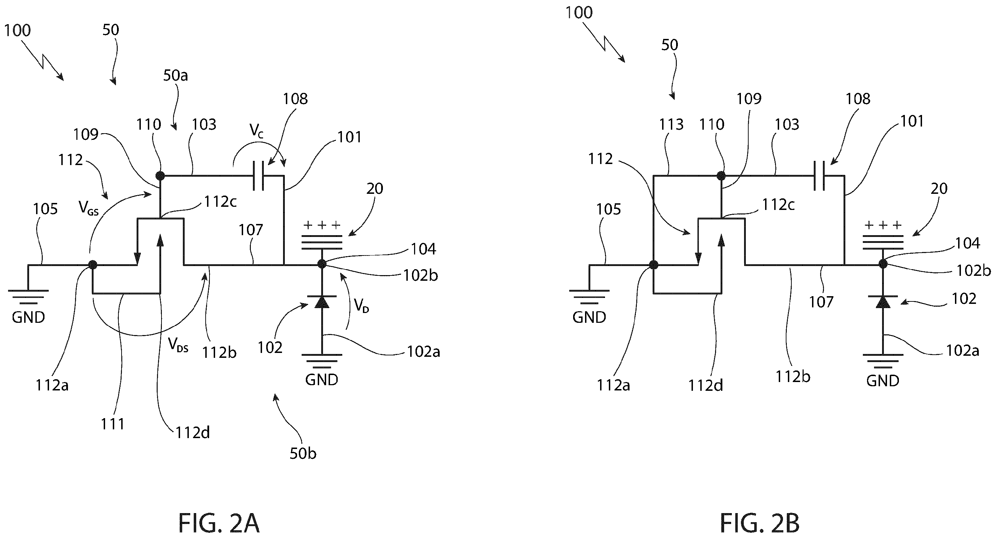

Figure 2A illustrates a circuit diagram of a protection circuit 50 for an integrated circuit 100 according to one embodiment of the present invention. In particular, the protection circuit 50 is part of the integrated circuit 100 and is manufactured concurrently with the integrated circuit 100.

Figure 2A illustrates the protection circuit 50 during a first step of the manufacturing process of the integrated circuit 100.

The protection circuit 50 is connected to other elements of the integrated circuit 100 at a node 104, as better illustrated below.

The integrated circuit 100 comprises a diode 102, having an anode 102a connected to a ground terminal GND and a cathode 102b connected to the node 104. One or more metal interconnects 20 of the integrated circuit 100 are connected to the node 104. As described with reference to Figure 1, such metal interconnects 20 act, during plasma-assisted processes, as collectors of electrical charges, generating the aforementioned "antenna effect". The protection circuit 50 further comprises a capacitor 108 having a capacitance C comprised between 0.1fF and 100fF, for example equal to 10fF, and including a first terminal coupled to the node 104 through a first metal connection 101 and a second terminal coupled to a gate node 110 through a second metal connection 103. The protection circuit 50 further comprises a high-voltage N-type MOS transistor (hereinafter referred to as the "HV-NMOS transistor") 112 of a type known per se, which includes a source terminal 112a coupled to the ground terminal GND through a third metal connection 105, a drain terminal 112b coupled to the node 104 through a fourth metal connection 107, a gate terminal 112c coupled to the gate node 110 through a fifth metal connection 109 and a body terminal 112d coupled to the source terminal 112a through a sixth metal connection 111. The HV-NMOS transistor 112 is configured to withstand maximum biasing voltages applied to the gate terminal 112c e.g. in the range between 3.6 V and 5.5 V. Furthermore, the HV-NMOS transistor 112 is configured to withstand expected biasing voltages for the node 104 during the operating conditions of the integrated circuit up to e.g. 100 V or even higher.

The ground terminal GND is at a reference potential V₀, e.g. equal to 0 V.

A manufacturing process of the integrated circuit 100, in particular a manufacturing process of the metal interconnects 20, includes deposition steps and masked etching steps of metal materials and dielectric materials. Such deposition and masked etching steps are carried out through plasma-assisted processes. During each plasma-assisted process, the progressively manufactured portions of metal interconnects 20 accumulate positive charges due to the antenna effect.

In presence of the accumulation of positive charges, the node 104 is at an electrical potential V₁ greater than the potential V₀. Therefore, a voltage drop V_{D} is present on the P-N junction diode 102, which causes a reverse bias thereof. The reverse bias of the P-N junction diode 102 prevents the dispersion of the accumulated positive charges towards the ground terminal GND.

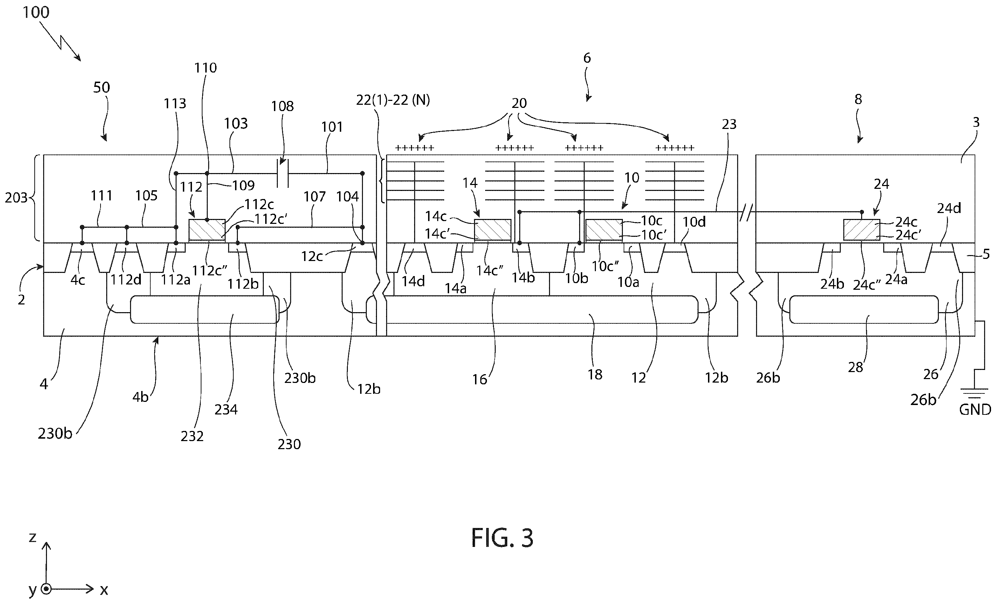

A first branch 50a of the protection circuit 50 comprises the ground terminal GND, the third metal connection 105, the source terminal 112a, the sixth metal connection 111, the body terminal 112d, the gate terminal 112c, the fifth metal connection 109, the gate node 110, the second metal connection 103, the capacitor 108, the first metal connection 101 and the node 104. The HV-NMOS transistor 112 comprises, in a manner known per se, a gate dielectric 112c" (described below with reference to Figure 3) and has a gate capacitance C_{G}. On the first branch 50a a voltage divider is formed between the capacitance C of the capacitor 108 and the gate capacitance C_{G} of the HV-NMOS transistor 112. The value of the capacitance C of the capacitor 108 and the value of the gate capacitance C_{G} of the HV-NMOS transistor 112 are designed or chosen in such a way that a voltage lower than a breakdown voltage of said gate dielectric 112c" drops on the gate dielectric 112c". In particular, the voltage divider is such that a voltage drop V_{GS} between the gate terminal 112c and the source terminal 112a of the HV-NMOS transistor 112 is a fraction comprised between 9/10 and 1/10, in particular equal to 1/2, of the voltage drop V_{D}. Similarly, a voltage drop V_{C} across the terminals of the capacitor 108 is a fraction comprised between 1/10 and 9/10, in particular equal to 1/2, of the voltage drop V_{D}.

A second branch 50b of the protection circuit 50 comprises the ground terminal GND, the third metal connection 105, the source terminal 112a, the drain terminal 112b, the fourth metal connection 107 and the node 104. On the second branch 50b, when the electrical charges accumulate due to the antenna effect at the node 104, a voltage drop V_{DS} is established between the drain terminal 112b and the source terminal 112a of the HV-NMOS transistor 112, equal to the voltage drop V_{D}. Therefore, the voltage drop V_{GS} is a fraction comprised between 9/10 and 1/10, in particular equal to 1/2, of the voltage drop V_{DS}.

As the number of positive charges accumulated at the node 104 increases, the value of voltage drop V_{D} increases. Consequently, the value of voltage drop V_{DS} and V_{GS} increases. When the voltage drop V_{D} exceeds a certain value depending on a tolerance of the circuit block to be protected, for example comprised between 0.6 V and 5 V, the voltage V_{GS} exceeds a turn-on threshold voltage V_{TH} (comprised between 0.5 V and 2 V, in particular 1 V) of the HV-NMOS transistor 112; a conductive channel of the HV-NMOS transistor 112 is therefore formed. Since the voltage drop V_{DS} is positive and greater than the voltage drop V_{GS}, the HV-NMOS transistor 112 is turned-on and withstands a current I_{ON} between the drain 112b and the source 112a terminals. The current I_{ON} flows from the node 104 through the fourth metal connection 107, the drain terminal 112b, the source terminal 112a, the third metal connection 105 and is discharged through the ground terminal GND, thereby dispersing the positive charges accumulated at the node 104 and reducing the voltage drop V_{D}. When the voltage drop V_{D} drops below a certain value, for example comprised between 0.6 V and 2 V, for example equal to 1 V, the voltage drop V_{GS} drops below the threshold voltage V_{TH} of the HV-NMOS transistor 112, which turns off.

During plasma-assisted processes, the HV-NMOS transistor 112 is adapted to turn on when the potential V₁ of the node 104 exceeds a predetermined value considered dangerous for the integrity of the integrated circuit 100 (e.g. V₁=3 V). During plasma-assisted processes, the HV-NMOS transistor 112 is also adapted to withstand a current I_{ON} such as to discharge the node 104 and turn off when the potential V₁ of the node 104 drops below said value deemed dangerous for the integrity of the integrated circuit 100, without the need for the application of external biasing voltages by voltage generators dedicated to this purpose.

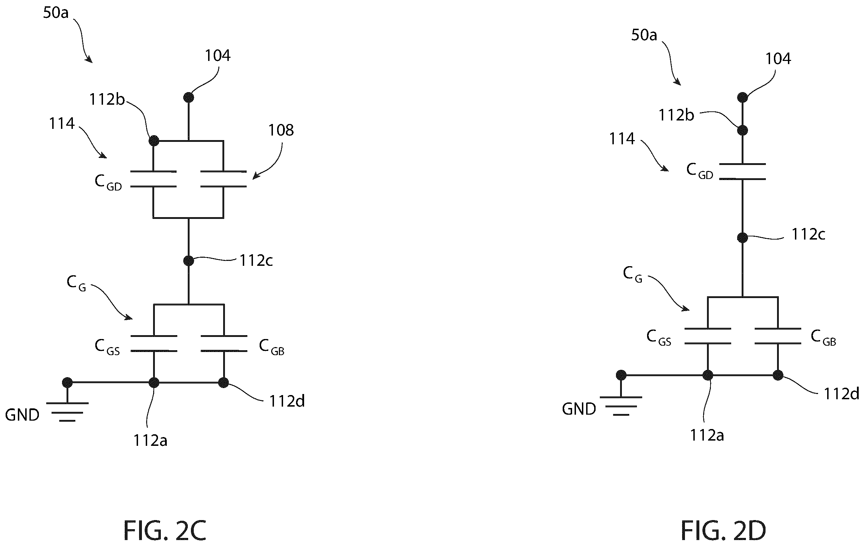

Figure 2C illustrates the first branch 50a of the protection circuit 50 wherein intrinsic capacitances of the HV-NMOS transistor 112 are shown. In detail, the branch 50a of the protection circuit 50 includes a gate-drain intrinsic capacitance C_{GD} between the drain terminal 112b and the gate terminal 112c of the HV-NMOS transistor 112, connected in parallel to the capacitor 108. The parallel between the capacitance C of the capacitor 108 and the intrinsic capacitance C_{GD} forms a capacitance 114 connected between the node 104 and the gate terminal 112c.

The intrinsic capacitance C_{GD} has for example a value comprised between 0.5 fF and 10 fF, in particular equal to 1fF.

The capacitance 114, during the operation of the protection circuit 50, operates similarly to what has been previously described with reference to the capacitor 108 of Figure 2A. The capacitance 114 has a higher value than the sole capacitance C of the capacitor 108, facilitating the turn-on of the HV-NMOS transistor 112, and is particularly suitable in case the circuit block to be protected is not capable of tolerating high voltages (e.g., voltages higher than 0.6 V).

The branch 50a of the protection circuit 50 also includes a gate-source intrinsic capacitance C_{GS} and a gate-body intrinsic capacitance C_{GB}, in parallel with each other and respectively connected between the gate terminal 112c and the source terminal 112a, and between the gate terminal 112c and the body terminal 112d. The parallel between the intrinsic capacitance C_{GS} and the intrinsic capacitance C_{GB} forms the gate capacitance C_{G} previously described, connected between the gate terminal 112c and the ground terminal GND and in series with the capacitance 114.

Figure 2D illustrates another embodiment of the first branch 50a of the protection circuit 50. In the embodiment illustrated in Figure 2D, the sole intrinsic capacitance C_{GD} is present between the gate terminal 112c and the drain terminal 112b. In this embodiment, the capacitor 108, the first metal connection 101 and the second metal connection 103 are not present. The operation of the protection circuit 50 is similar to what has been described with reference to Figure 2A. In particular, the intrinsic capacitance C_{GD} operates similarly to the capacitor 108 as previously described. The embodiment described with reference to Figure 2D requires a smaller circuit area and is suitable in case the circuit block to be protected is capable of tolerating high voltages (e.g. up to 2.5 V).

Figure 2B illustrates the protection circuit 50 of Figure 2A during a second manufacturing step of the integrated circuit 100, in particular at the end of the manufacturing of the integrated circuit 100. In Figure 2B, elements of the protection circuit 50 that are in common with the protection circuit 50 of Figure 2A are indicated by the same reference numerals and are not further described.

The protection circuit 50 of Figure 2B includes a seventh metal connection 113 that connects the gate node 110 to the source terminal 112a of the HV-NMOS transistor 112. In one embodiment, the seventh metal connection 113 is formed, at least in part, within the last metal layer of the metal interconnects 20. For example, the seventh metal connection 113 is formed by short-circuiting portions of the metal interconnects 20 connected to the gate node 110 and the source terminal 112a, respectively.

The seventh metal connection 113 is then configured to short-circuit the gate terminal 112c with the source terminal 112a of the HV-NMOS transistor 112 at the end of the manufacturing process of the metal interconnects 20. Consequently, in the protection circuit 50, at the end of the manufacturing process, the voltage drop V_{GS} between said gate 112c and source 112a terminals is forced to a value equal to 0 V, forcing the HV-NMOS transistor 112 into the off state, regardless of the potential value V₁ of the node 104. The HV-NMOS transistor 112 is therefore turned off without the need to apply external biasing voltages to the HV-NMOS transistor 112 by voltage generators dedicated to this purpose. By turning off the HV-NMOS transistor 112 as described, the node 104 is allowed to reach the operating voltage without unwanted leakage of current towards the ground terminal GND and in particular such voltages may be even higher than that to which using the integrated circuit 100 is limited during the process.

It should be noted that the operation of the protection circuit 50 described with reference to Figure 2B is independent of whether the first branch 50a of the circuit 50 is provided according to the embodiment of Figure 2A, 2C or 2D.

Figure 3 schematically illustrates a wider portion of the integrated circuit 100, including the protection circuit 50 described with reference to Figures 2A-2B. In particular, Figure 3 illustrates this portion of the integrated circuit 100 in a triaxial system of axes x, y, z, orthogonal to each other, in a lateral sectional view on the xz plane, and using a mixed graphic representation that has structural elements and circuit diagrams, for ease of representation and comparison with Figures 2A-2B.

The protection circuit 50 is electrically connected, through the node 104, to a circuit of the type illustrated in Figure 1, and formed respectively by the first circuit block 6 and the second circuit block 8, described with reference to Figure 1. The first circuit block 6, the second circuit block 8 and the protection circuit 50 form, as a whole, the integrated circuit 100.

Elements of the first and the second circuit blocks 6, 8 described with reference to Figure 1 are identified in Figure 3 with the same reference numerals and are not further described, unless appropriate for a better understanding of the embodiment described.

In particular, the integrated circuit 100 comprises the solid body 2, which in turn includes the substrate 4, the dielectric layer 3 and the patterned oxide layer 5 that extends at the first face 4a of the substrate 4. More in particular, the dielectric layer 3 in turn comprises a stack of dielectric layers 203 (also referred to as "dielectric stack 203" in the following) extending on the substrate 4, in direct contact with the first face 4a of the substrate 4 and with the patterned oxide layer 5.

The patterned oxide layer 5 has openings through which the face 4a of the substrate 4 is exposed. The patterned oxide layer 5 is, for example, formed by masked oxidation of the substrate 4, deposition of insulating material (e.g., silicon oxide) or yet, alternatively, by etching steps of the substrate 4 and deposition steps of silicon oxide within the etched regions, until they are filled. The insulating layer 5 has, for example, a thickness, along the z axis comprised between 0.1 µm and 0.5 µm (boundaries of the range included), in particular equal to 0.35 µm.

The substrate 4 is in particular of semiconductor material, such as for example silicon (Si), silicon carbide (SiC), etc. The substrate 4 may alternatively be of SOI ("Silicon Over Insulator") type.

The substrate 4 has a first electrical conductivity, for example of the P-type, with a concentration of doping species comprised in the range 1x10¹⁴ at/cm³ - 1x10¹⁸ at/cm³, for example equal to 1x10¹⁵ at/cm³. In one embodiment, the substrate 4 comprises a plurality of superimposed layers, for example a plurality of layers of semiconductor material. In a further embodiment, the substrate 4 is a single layer. The substrate 4 has, for example, a thickness along the z axis comprised between 100 µm and 1000 µm (boundaries of the range included), in particular equal to 725 µm. The substrate 4 forms, at least in part, the anode 102a of the P-N junction diode 102 described in reference to Figure 2A, and is connected to the ground terminal GND. During manufacturing, the substrate 4 is for example capacitively coupled to a substrate holder adapted to operate as a ground terminal GND.

The substrate 4 also includes the first doped region ("first N-WELL") 12, the second doped region ("second N-WELL") 26 and a third doped region ("third N-WELL") 230 having a second electrical conductivity opposite to the first electrical conductivity, for example of the N-type, with a concentration of doping species comprised in the range 1x10¹⁶ at/cm³ - 1x10¹⁸ at/cm³, for example equal to 1x10¹⁷ at/cm³. The first N-WELL 12, the second N-WELL 26 and the third N-WELL 230 are at a distance from each other. The protection circuit 50 comprises the third N-WELL 230.

The substrate 4 also includes a first ohmic contact region 4c in direct contact with the dielectric stack 203 through a respective opening in the patterned oxide layer 5; the first ohmic contact region 4c has the first electrical conductivity (P), and a concentration of doping species in particular comprised in the range 1x10¹⁹ at/cm³ - 4x10²⁰ at/cm³, for example equal to 2x10²⁰ at/cm³. The first ohmic contact region 4c is adapted to form an electrical contact with the substrate 4. The first N-WELL 12, the second N-WELL 26, the third N-WELL 230 and the first ohmic contact region 4c extend facing the first face 4a and also extend in depth into the substrate 4, terminating within the substrate 4 without reaching the second face 4b of the substrate 4. The first N-WELL 12, the second N-WELL 26 and the third N-WELL 230 are in direct physical contact with the dielectric stack 203 through respective openings of the patterned oxide layer 5.

The first N-WELL 12, the second N-WELL 26 and the third N-WELL 230 are laterally delimited respectively by a first 12b, a second 26b and a third 230b peripheral portion, forming respective P-N junctions with respective portions of the substrate 4.

The substrate 4 also includes the first buried region ("first DNW") 18, the second buried region ("second DNW") 28 and a third buried region ("third DNW") 234, which extend buried into the substrate 4. In particular, the third DNW 234 extends in part within the third N-WELL 230 and in part within the portion of the substrate 4 comprised between the third N-WELL 230 and the second face 4b, and is therefore in direct electrical contact with the third N-WELL 230.

In particular, the first DNW 18, the second DNW 28 and the third DNW 234 have a respective concentration of N-type doping species comprised between 1x10¹⁷ at/cm³ - 1x10²⁰ at/cm³, for example equal to 1x10¹⁹ at/cm³.

The first DNW 18, the second DNW 28 and the third DNW 234 form with respective portions of the substrate 4 respective P-N junctions that extend adjacent and in electrical continuity with the P-N junctions formed between the substrate 4 and the first N-WELL 12, the second N-WELL 26 and the third N-WELL 230. When reversely biased, such P-N junctions electrically insulate the first N-WELL 12, the second N-WELL 26 and the third N-WELL 230 from the substrate 4.

In one embodiment, the first N-WELL 12 includes a second ohmic contact region 12c, having the second electrical conductivity (N), and a concentration of doping species higher than the concentration of doping species of the N-WELLs 12, 26, 230, and in particular comprised in the range 1x10¹⁹ at/cm³ - 4x10²⁰ at/cm³, for example equal to 2x10²⁰ at/cm³. The second ohmic contact region 12c extends at the face 4a and is in direct contact with the dielectric stack 203 through a respective opening in the insulating layer 5. At least part of the first N-WELL 12 forms the cathode 102b of the P-N junction diode 102. The second ohmic contact region 12c of the first N-WELL 12 forms, at least in part, the node 104.

In the embodiment of Figure 3, similarly to what has been described in reference to Figure 1, the first N-WELL 12 accommodates the source 10a and drain 10b terminals of the first P-MOS transistor 10, and the second N-WELL 26 accommodates the source 24a and drain 24b terminals of the second P-MOS transistor 24. The gate terminals 10c, 24c of the first and the second P-MOS transistors 10, 24 comprise in a manner known per se, respective gate conductive portions 10c', 24c' and gate dielectrics 10c", 24c", extending into the dielectric stack 203.

The first N-WELL 12 and the third N-WELL 230 include respectively the first doped sub-portion ("first P-WELL") 16 and a second doped sub-portion ("second P-WELL") 232, having the first electrical conductivity (P), and a concentration of doping species higher than the concentration of doping species of the N-WELLs 12, 230, and in particular comprised in the range 1x10¹⁶ at/cm³ - 1x10¹⁸ at/cm³, for example equal to 1x10¹⁷ at/cm³.

The first P-WELL 16 and the second P-WELL 232 extend facing the first face 4a and in depth into the substrate 4. In plan view on the xy plane, the first P-WELL 16 and the second P-WELL 232 are completely surrounded, respectively, by the first N-WELL 12 and the third N-WELL 230.

The first P-WELL 16 accommodates the source 14a and drain 14b terminals of the N-MOS transistor 14.

The second P-WELL 232 accommodates the source terminal 112a, the drain terminal 112b and the body terminal 112d of the HV-NMOS transistor 112. The gate terminals 14c and 112c respectively of the N-MOS transistor 14 and the HV-NMOS transistor 112 comprise, in a manner known per se, respective gate conductive portions 14c', 112c' and respective gate dielectrics 14c", 112c", extending into the dielectric stack 203 at the first face 4a of the substrate 4.

In a further embodiment (not illustrated) the first N-WELL 12 includes a plurality of P-MOS transistors and a plurality of P-WELLs which in turn include, at least in part, respective N-MOS transistors. In a further embodiment, the second N-WELL 26 also similarly includes a plurality of P-MOS transistors and one or more P-WELLs, which in turn include, at least in part, one or more respective N-MOS transistors.

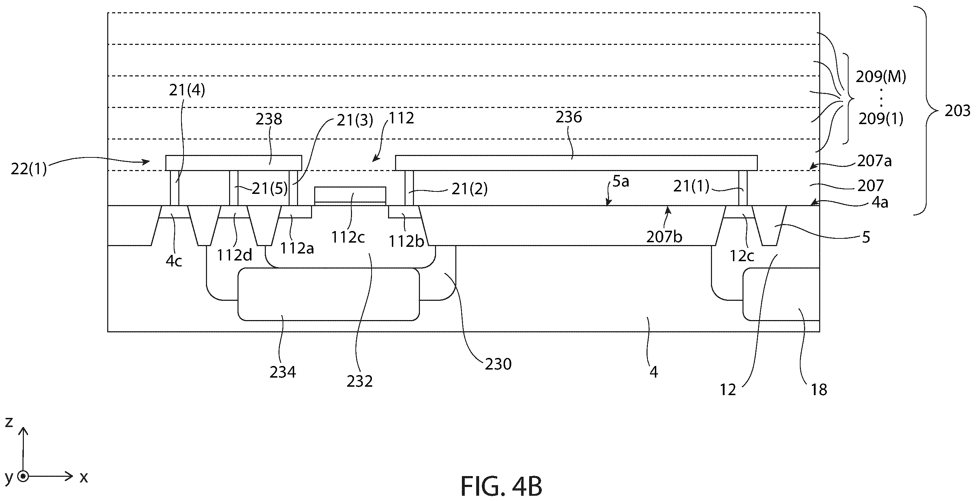

The dielectric stack 203 comprises a pre-metal dielectric layer 207 (illustrated and described in greater detail with reference to Figures 4B-4C) and a plurality of layers of inter-metal dielectric layers 209(1)-209(M) (illustrated and described in greater detail with reference to Figures 4B-4C). The dielectric stack 203 has, for example, a thickness along the z axis comprised between 1 µm and 10 µm (boundaries of the range included), in particular equal to 5 µm.

The dielectric stack 203 also accommodates the one or more metal interconnects 20. The metal interconnects 20 comprise one or more metal layers 22(1)-22(N) (described in greater detail below, with reference to Figures 4B-4C), and a plurality of metal through vias 21(1)-21(L) that electrically connect the metal layers 22(1)-22(N) to each other and to the substrate 4.

The metal connection 23 electrically couples the gate terminal 24c of the second P-MOS transistor 24 with the drain terminals 10d, 14d of the first P-MOS transistor 10 and of the N-MOS transistor 14, in particular through the first metal layer 22(1) and respective metal through vias.

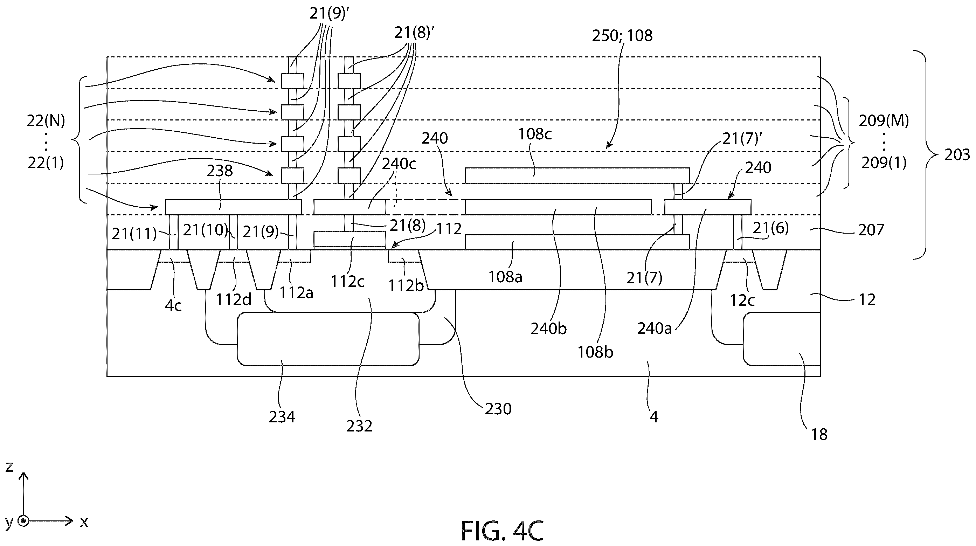

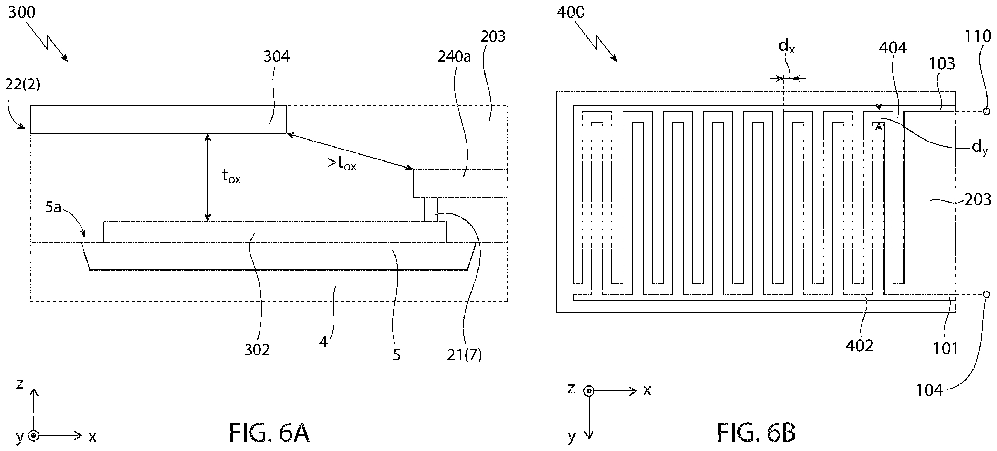

The dielectric stack 203 also includes the metal connections 101, 103, 105, 107, 109, 111 and 113 of the protection circuit 50 described with reference to Figures 2A and 2B, formed through the metal interconnects 20, and the capacitor 108 (the latter described in detail with reference to Figures 4C and 6A-6B). In particular, the first metal connection 101 connects the second ohmic contact region 12c to the first terminal of the capacitor 108, the second metal connection 103 connects the second terminal of the capacitor 108 to the gate node 110, the third metal connection 105 connects the source terminal 112a to the first ohmic contact region 4c and therefore to the substrate 4 (which forms the ground terminal GND). The fourth metal connection 107 connects the drain terminal 112b to the second ohmic contact region 12c, the fifth metal connection 109 connects the gate node 110 to the gate terminal 112c, electrically coupling the second terminal of the capacitor 108 with the gate terminal 112c. Furthermore, the sixth metal connection 111 connects the body terminal 112d to the first ohmic contact region 4c. When present (i.e., as mentioned, at the end of the manufacture of the integrated circuit 100), the seventh metal connection 113 connects the gate node 110 to the source terminal 112a.

The metal connections 101, 103, 105, 107, 109, 111 may be formed at a same metal layer (e.g. the first metal layer 22(1)). The capacitor 108, described with reference to Figure 2A, may also be formed in the same metal layer as the metal connections 101, 103, 105, 107, 109, 111. However, other embodiments are possible, as illustrated below with reference to Figures 4C, 5B and 6A-6B. For example, at least some of the metal connections 101, 103, 105, 107, 109, 111 may be formed in respective metal layers 22(1)-22(N) that are different from each other.

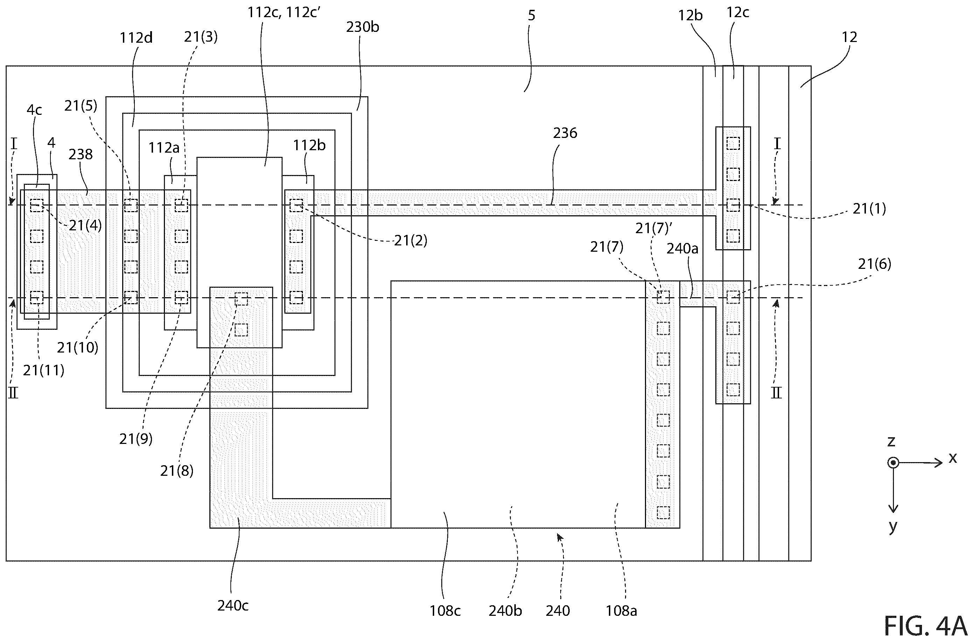

Forming the metal connections 101, 103, 105, 107, 109, 111 and the capacitor 108 by exploiting the first metal layer 22(1), ensures the operability of the HV-NMOS transistor 112 (and therefore protection from plasma-induced damages) during the manufacturing steps successive to a patterning step of the first metal layer 22(1), at least up to the deposition of the last metal layer 22(N). In one embodiment wherein the capacitor 108 is formed at least in part at the first metal layer 22(1), the solid body 2 further includes a conductive region 108a (illustrated in Figures 4A, 4C, 5A-5B and 6A), which extends into the pre-metal dielectric layer 207. The conductive region 108a is adapted to form, at least in part, a first plate of the capacitor 108.

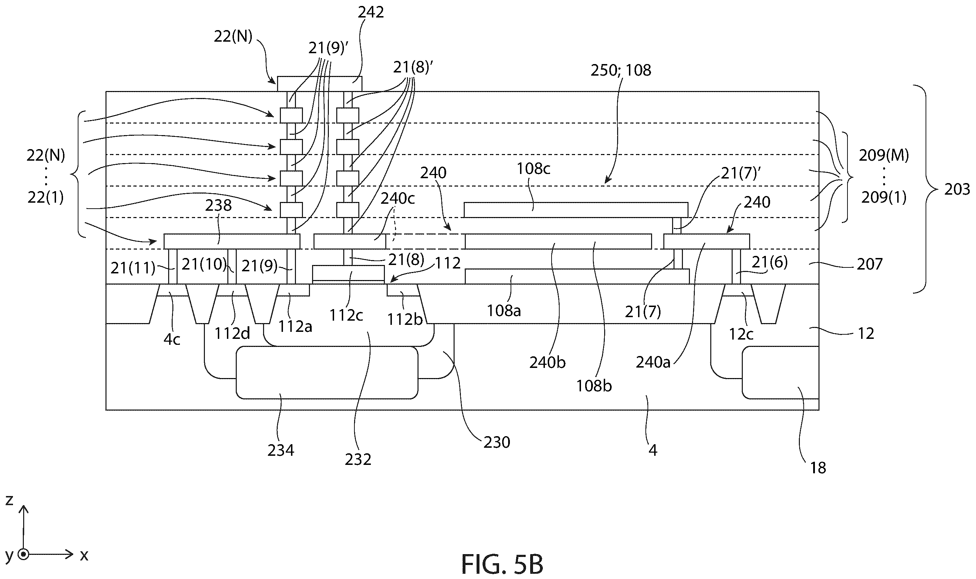

In one embodiment, the metal connection 113, described with reference to Figure 2B, is formed in the last metal layer 22(N) (see Figure 5B).

Figure 4A schematically illustrates the protection circuit 50 described with reference to Figure 2A, in top view on the xy plane, according to one embodiment of the present invention and limitedly to some elements relevant for the understanding of the invention. Figures 4B-4C schematically illustrate respective portions of the protection circuit 50 described with reference to Figure 2A, in lateral sectional view on the xz plane, where the lateral sectional views of Figures 4B-4C are taken along a scribe line I-I and along a scribe line II-II of Figure 4A, respectively. In Figures 4A-4C, elements of the protection circuit 50 that are in common with the protection circuit 50 of Figures 2A-2B and 3 are indicated with the same reference numerals and are not further described where not appropriate.

As illustrated in Figures 4B-4C, the pre-metal dielectric layer 207 and the inter-metal dielectric layers 209(1)-209(M) form, as a whole, the dielectric stack 203. In one embodiment, the pre-metal dielectric layer 207 and the inter-metal dielectric layers 209(1)-209(M) are of a respective insulating or dielectric material such as for example silicon oxide (SiO₂), silicon nitride (Si₃N₄), aluminum oxide (Al₂O₃), etc.

The one or more metal layers 22(1)-22(N-1) illustrated in Figures 4B-4C extend parallel to the xy plane within the dielectric layer 203, at a distance from the first face 4a of the substrate 4 and at a distance from each other along the z axis. The first metal layer 22(1) is, among the metal layers 22(1)-22(N), the closest to the first face 4a of the substrate 4, while the metal layer 22(N) (not illustrated in Figures 4B-4C) is the last metal layer, that is, among the metal layers 22(1)-22(N), the farthest from the first face 4a of the substrate 4; the metal layers 22(2)-22(N-1) extend between the first metal layer 22(1) and the last metal layer 22 (N).

In detail, the first metal layer 22(1) has a first side facing the first face 4a of the substrate 4 and a second side, opposite to the first side along the z axis, facing the second metal layer 22(2). The pre-metal dielectric layer 207 extends at least in part between the substrate 4 and the first metal layer 22(1), and has a first surface 207a in direct physical contact with the first metal layer 22(1), and a second surface 207b opposite to the first along the z axis, in direct physical contact with the first face 4a of the substrate 4 and with a first surface 5a of the insulating layer 5. The individual inter-metal dielectric layers 209(1)-209(M) extend at least in part respectively interposed between, and in direct physical contact with, the metal layers 22(1)-22(N-1). The number M of inter-metal dielectric layers 209(1)-209(M) may assume a value that is lower than, equal to, or greater than the number N of metal layers 22(1)-22(N) depending on the manufacturing process of the integrated circuit 100.

The metal layers 22(1)-22(N) are for example of copper (Cu) or aluminum (Al), with a thickness comprised between 0.1 µm and 10 µm. The metal vias 21(1)-21(L) are for example of copper (Cu) or tungsten (W).

With reference to Figures 4A-4B, a first portion 236 of the first metal layer 22(1) extends with a main dimension parallel to the x axis, between a first end thereof placed at the second ohmic contact region 12c and a second end thereof placed at the drain terminal 112b, said first portion 236 being electrically coupled to the second ohmic contact region 12c (node 104) through a metal via 21(1) and to the drain terminal 112b through a respective metal via 21(2), thus forming at least in part the fourth metal connection 107.

A second portion 238 of the first metal layer 22(1) extends at a distance from the first portion 236 on the xy plane, with a main dimension parallel to the x axis, has a first end at the source terminal 112a and a second end at the first ohmic contact region 4c, and is coupled to the source terminal 112a and the first ohmic contact region 4c respectively through a metal via 21(3) and a further metal via 21(4), thus forming at least in part the third metal connection 105. The second portion 238 of the first metal layer 22(1) is also electrically coupled, at a region comprised between its first and its second ends, with the body terminal 112d at least through a metal via 21(5), thus forming (with the metal via 21(4)) the metal connection 111.

Figure 4C illustrates, in a non-limiting manner, one embodiment of the first branch 50a of the protection circuit 50.

With reference to Figures 4A and 4C, a third portion 240 of the first metal layer 22(1) extends on the xy plane at a distance from the first portion 236 and the second portion 238 and has a first end at the second ohmic contact region 12c (node 104) and a second end at the gate terminal 112c.

The third portion 240 is also divided into three sub-portions 240a, 240b, 240c. The first sub-portion 240a extends between a first end at the second ohmic contact region 12c and a second end at a peripheral portion of the first plate 108a and is coupled to the second ohmic contact region 12c through a respective metal via 21(6) and to the first plate 108a through a further respective metal via 21(7). The second sub-portion 240b extends, in plan view on the xy plane, at the first plate 108a at a distance from the first sub-portion 240a. The second sub-portion 240b has a first end facing, and at a distance from, the first sub-portion 240a and a second end in electrical contact with the third sub-portion 240c. In particular, the second sub-portion 240b forms at least in part a second plate 108b of the capacitor 108. The third sub-portion 240c has a first end in electrical contact with the second sub-portion 240b and a second end at the gate terminal 112c, is electrically coupled with the gate terminal 112c of the HV-NMOS transistor 112 through a metal via 21(8), thus forming the fifth electrical connection 109.

A portion 108c of the second metal layer 22(2) extends, in view on the xy plane, at the first plate 108a and the second plate 108b, on the first inter-metal dielectric layer 209(1), and is coupled, at one end, with the first sub-portion 240a through a metal via 21(7)'. In one embodiment, the first plate 108a, the second plate 108b and the third plate 108c have, in view on the xy side, a polygonal shape, substantially square or rectangular, with respectively a first dimension Lxa, Lxb, Lxc along the x axis comprised between 1 µm and 100 µm; and a respective second dimension Lya, Lyb, Lyc along the y axis comprised between 1 µm and 100 µm.

The conductive region 108a is for example of metal material or doped polysilicon (Poly-Si), with an N-type electrical conductivity, and a concentration of doping species comprised between 1x10¹⁹ at/cm³ and 2x10²¹ at/cm³, in particular equal to 1x10²¹ at/cm³. The conductive region 108a may for example be patterned during steps of the manufacturing process adapted to form said conductive portions 210c', 214c', 224c', 112c'.

Therefore, the first plate 108a, the second plate 108b and the third plate 108c form a capacitor 250 that implements the capacitor 108 of Figures 2A and 2B, according to one embodiment.

The capacitance C of the capacitor 250 depends on the extension on the xy plane of the first plate 108a and of the second plate 108b and of the third plate 108c, on the thickness of the pre-metal dielectric layer 207, on the thickness of the first inter-metal dielectric layer 209(1) and on the respective dielectric constants of the pre-metal dielectric layer 207 and of the first inter-metal dielectric layer 209(1). The capacitor 250 has a high specific capacitance, comprised for example between 0.01 µF/cm² and 0.1 µF/cm², in particular for example equal to 0.02 µF/cm².

The capacitor 250 provides at the same time a reduced first parasitic capacitance between the substrate 4 and the gate node 110 and a reduced second parasitic capacitance between the gate node 110 and the metal layers 22(3)-22(N) higher than the second 22(2). In particular, since the first plate 108a is at least in part interposed between the substrate 4 and the first metal layer 22(1), the first parasitic capacitance is reduced. This reduction of the first parasitic capacitance favors capacitive coupling between the gate node 110 and the node 104 through the capacitor 250, facilitating the turn-on of the HV-NMOS transistor 112 when necessary. The reduction of the second parasitic capacitance is a consequence of the presence of the third plate 108c, at least in part interposed between the first metal layer 22(1) and the metal layers 22(3)-22(N). The reduction of the second parasitic capacitance favors the shielding of the gate node 110, and thus of the gate terminal 112c, with respect to the upper metal layers 22(3)-22(N), facilitating the turn-off of the HV-NMOS transistor 112 once the manufacturing process of the integrated circuit 100 has ended.

Further metal vias 21(8)' extend through the dielectric stack 203 above the metal via 21(8) and align with the metal via 21(8) along the z axis, contacting the metal layers 22(1)-22(N-1), and thus forming, as a whole, an electrical connection adapted to contact the last metal layer 22(N). In particular, since the third sub-portion 240c of the first metal layer 22(1) and the metal vias 21(8), 21(8)' are electrically connected to each other, they represent, as a whole, the gate node 110.

Again with reference to Figure 4C, the second portion 238 of the first metal layer 22(1) is also electrically coupled with the source terminal 112a, with the body terminal 112d and with the first ohmic contact region 4c at least through, respectively, a metal via 21(9), a metal via 21(10) and a metal via 21(11). Metal vias 21(9)' extend through the dielectric stack 203, above the metal via 21(9) and aligned, along the z axis, with the metal via 21(9). The metal vias 21(9)' contact a plurality of metal layers 22(1)-22(N-1), forming an electrical connection adapted to contact the last metal layer 22(N).

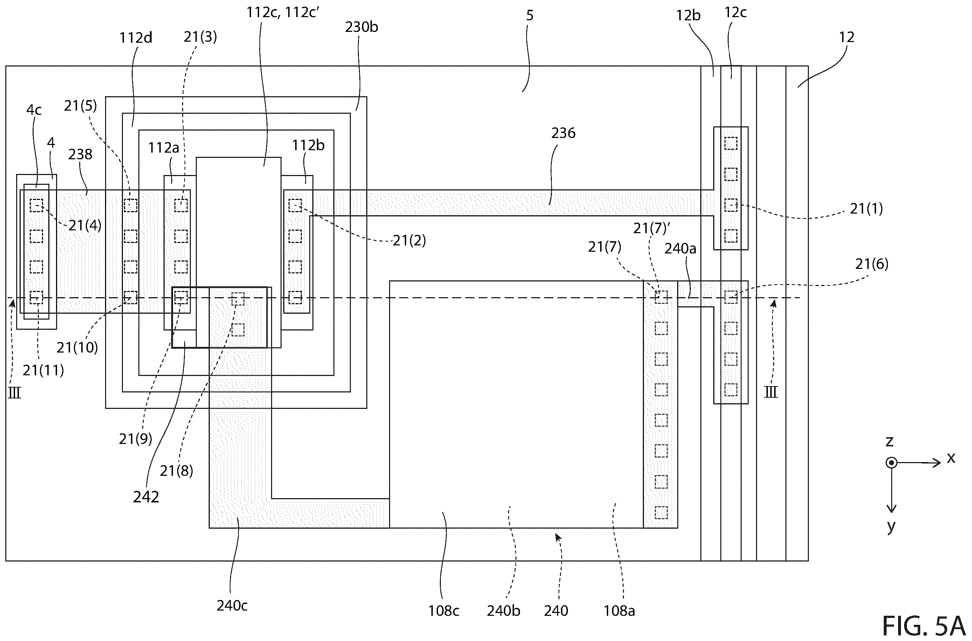

Figure 5A schematically illustrates the protection circuit 50 in the manufacturing step of Figure 2B, in a top view on the xy plane, and limitedly to some elements useful for understanding the invention. Figure 5B schematically illustrates the protection circuit 50 in the manufacturing step of Figure 2B, in a lateral sectional view on the xz plane, taken along a scribe line III-III of Figure 5A.

In Figures 5A-5B, elements of the protection circuit 50 that are in common with the protection circuit 50 of Figures 2A-2B, 3 and 4A-4C are indicated with the same reference numerals and are not further described.

With reference to Figures 5A-5B, a portion 242 of the last metal layer 22(N) extends between the gate terminal 112c and the source terminal 112a and is electrically coupled to the gate terminal 112c through the succession of metal vias 21(8)' and to the source terminal 112a through the succession of metal vias 21(9)', thus forming the metal connection 113.

Figures 6A and 6B schematically illustrate respective embodiments of a capacitor 300 and a capacitor 400, to form the capacitor 108 of Figures 2A and 2B, according to alternative embodiments to those of Figures 4C and 5B.

Figure 6A schematically illustrates the capacitor 300, in a lateral sectional view on the xz plane.

The capacitor 300 includes a first electrically conductive plate 302 and a second electrically conductive plate 304. In one embodiment, the second plate 304 is for example a portion of the second metal layer 22(2). In another embodiment (not illustrated), the second plate 304 is a portion of one of the metal layers 22(3)-22(N-1).

The first plate 302 extends in contact with the surface 5a of the insulating layer 5.

A portion of dielectric stack 203 with a thickness tₒₓ along the z axis extends between the first plate 302 and the second plate 304.

A capacitance C' of the capacitor 300 depends, in a manner known per se, at least on an extension on the xy plane of the first plate 302 and of the second plate 304, on the thickness tₒₓ and on a dielectric constant of the portion of dielectric stack 203 extending between the first plate 302 and the second plate 304. The capacitor 300 has a specific capacitance, comprised for example between 0.05 µF/cm² and 0.1 µF/cm², in particular for example equal to 0.01 µF/cm².

Figure 6B illustrates a capacitor 400 according to a further embodiment, in a top-plan view on the xy plane.

The capacitor 400 is a type of planar "metal-oxide-metal" (MOM) capacitor, and includes a first portion of the first metal layer 22(1) forming a first electrode 402 and a second portion of the first metal layer 22(1) forming a second electrode 404. The first electrode 402 and the second electrode 404 are at least in part patterned in a comb shape, and mutually inter-digitated. In one embodiment, the first electrode 402 of the capacitor 400 is coupled to the node 104 of the protection circuit 50 through the first metal connection 101 and the second electrode 404 of the capacitor 400 is coupled to the gate node 110 of the protection circuit 50 through the second metal connection 103, or vice versa.

A capacitance C" of the capacitor 400 depends, in a manner known per se, at least on a distance dₓ between the first electrode 402 and the second electrode 404 along the x axis and on a distance d_{y} between the first electrode 402 and the second electrode 404 along the y axis. In the embodiment illustrated in Figure 6B, the distance dₓ is equal to the distance d_{y}. The distances dₓ and d_{y} between the first electrode 402 and the second electrode 404 are patterned during the manufacturing process, for example through a photolithography step followed by a masked etching step of the first metal layer 22(1). Therefore, by appropriately sizing such distances dₓ and d_{y}, the capacitor 400 may be configured to withstand a desired fraction V_{c}" of the voltage drop V_{D} thereacross. For example, by sizing the distances dₓ and d_{y} equal to each other and in the range 0.2 µm - 1.0 µm, the capacitor 400 may withstand voltage drops V_{C}" in the range 20 V - 100 V.

The capacitor 300 and the capacitor 400 may withstand a respective voltage greater than the voltage V_{C} that the capacitor 250 may withstand. The voltage V_{C} that the capacitor 250 may withstand is in fact limited by a breakdown voltage threshold of the pre-metal dielectric layer 207 and/or by a breakdown voltage threshold of the first inter-metal dielectric layer 209(1), such voltages depending on a thickness of the respective layers 207, 209(1).

In embodiments of the integrated circuit 100 wherein the pre-metal dielectric 207 and inter-metal dielectric 209(1) layers have a limited thickness, for example in the range 100 nm - 1000 nm, the capacitor 300 allows voltage drops greater than V_{C} to be withstood. This is due to the thickness tₒₓ of the portion of dielectric stack 203 interposed between the first plate 302 and the second plate 304, which is greater than the thicknesses of the individual layers 207, 209(1). However, when the capacitor 300 is used to implement the capacitor 108 in the protection circuit 50, the HV-NMOS transistor 112 is not activatable in all the process steps preceding the manufacturing of the second plate 304. In this case, therefore, the capacitor 400 may be used, to make the HV-NMOS transistor 112 activatable starting from a step immediately following a patterning step of the metal layer 22(1), and wherein the voltage drop withstandable by the capacitor 250 is not sufficiently high.

The fraction of the voltage drop V_{D} corresponding to the voltage drop V_{GS} between the gate terminal 112c and the source terminal 112a of the HV-NMOS transistor 112, depends, as previously described, on the capacitive voltage divider resulting from the series of the capacitor 250; 300; 400 with the gate capacitance of the HV-NMOS transistor 112. By appropriately sizing the capacitances C, C', C" of the respective capacitors 250, 300, 400, the fraction of voltage drop adapted to act between the gate terminal 112c and the source terminal 112a of the HV-NMOS transistor 112 during the manufacturing process steps performed through plasma-assisted processes may be configured.

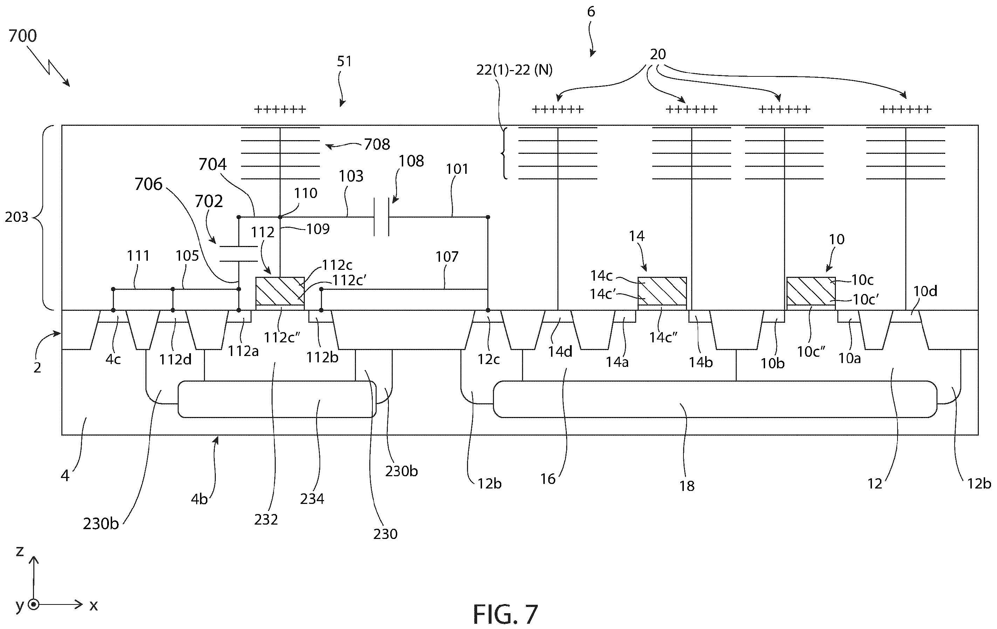

Figure 7 schematically illustrates a portion of an integrated circuit 700 comprising a protection circuit 51 according to another embodiment of the present invention, connected to the first circuit block 52 through the node 104. In particular, Figure 7 illustrates the integrated circuit 700 in a triaxial system of axes x, y, z orthogonal to each other, in a lateral sectional view on the xz plane and with some elements shown in circuit representation. In Figure 7, elements of the integrated circuit 700 that are in common with the integrated circuit 100 of Figure 3 are indicated with the same numerical references and are not further described.

The protection circuit 51 comprises a gate-source coupling capacitor 702 having a capacitance C_{GS} comprised between 0.1 fF and 10 fF, for example equal to 1 fF, further having a first end coupled to the gate node 110 through a metal connection 704 and a second end coupled to the source terminal 112a through a further metal connection 706. In one embodiment, the gate-source coupling capacitor 702 is of the same type as the capacitor 108 (i.e., implementable according to the embodiments of the capacitors 250, 300 and 400 described). In one embodiment wherein the gate-source coupling capacitor 702 is similar to the capacitor 250 or the capacitor 400, the metal connections 704 and 706 extend, at least in part, into the first metal layer 22(1).

In one embodiment, the protection circuit 51 further includes further metal interconnects 708 that, during plasma treatments, act as an antenna electrically coupled to the gate node 110.

In the protection circuit 51, during a plasma-assisted process, the voltage drop V_{GS} between the gate terminal 112c and the source terminal 112a of the HV-NMOS transistor 112 is given by the sum of a first contribution and a second contribution. The first contribution is given by the voltage drop due to a voltage divider wherein the capacitor 108 is placed in series with the parallel between the gate capacitance of the HV-NMOS transistor 112 and the capacitor 702. The second contribution is given by the voltage drop provided by the plasma through the antenna 708.

By appropriately sizing the capacitance C_{GS} of the gate-source coupling capacitor 702 and the capacitance of the capacitor 108, based on the operating voltage of the first N-WELL 12, the HV-NMOS transistor 112 may be prevented from turning on during the life cycle of the integrated circuit 700, without the need to apply external biasing voltages by voltage generators dedicated to this purpose. At the same time, in the protection circuit 51, since the gate terminal 112c is not short-circuited to the source terminal 112a through the metal connection 113 illustrated in Figure 3, the HV-NMOS transistor 112 is activatable during the processing steps of the last metal layer 22(N).

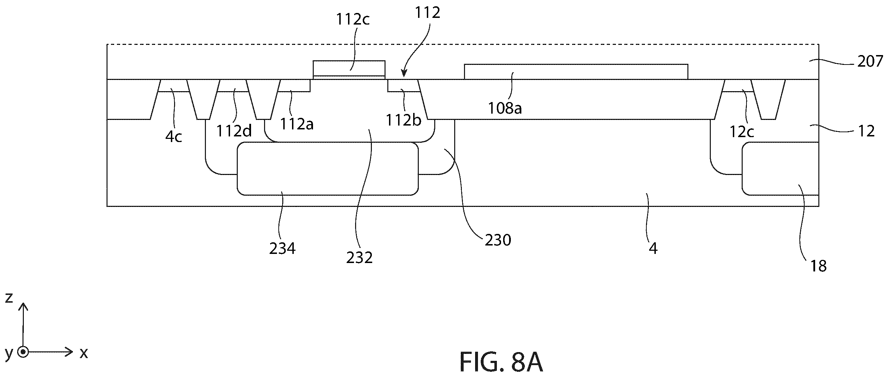

With reference to Figures 8A-8F, manufacturing steps of the portion of the protection circuit 50 illustrated in Figure 5C are now described, limitedly to the formation of the metal connections 101, 103, 105, 107, 109, 111 and 113 and in part of the capacitor 250. Figures 8A-8F are lateral sectional views on the xz plane.

With reference to Figure 8A, after having formed the substrate 4 and the doped regions accommodated in the substrate 4 and previously described, the gate dielectric 112c", the conductive portion 112c' and the first plate 108a in a manner known per se, a deposition step of the pre-metal dielectric layer 207 is performed, for example by PECVD, followed by a planarization step, for example by chemical-mechanical polishing (CMP).

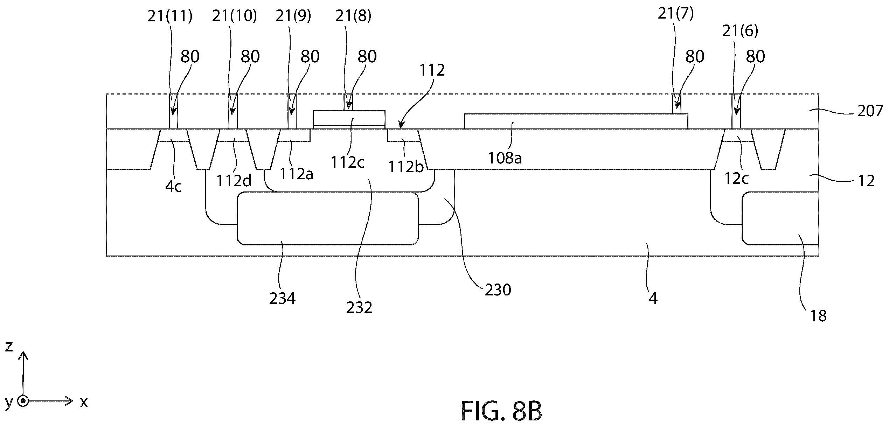

With reference to Figure 8B, there are performed one or more masked etching steps (e.g., by photolithography steps followed by RIE or Deep-RIE steps, known per se) of the pre-metal dielectric layer 207 up to reaching the first surface 204a of the structural layer 204 and respective surfaces of the conductive portion 112c' and of the first plate 108a, thus obtaining trenches 80. There are then performed one or more metal material deposition steps (e.g., sputtering steps followed by electroplating steps) up to completely filling the trenches 80, followed by masked etching steps of said metal material to selectively remove it from the first surface 207a of the pre-metal dielectric layer 207. Respective first portions of the metal vias 21(6)-21(11) are thus obtained. It should be noted that in this step, respective first portions of the other metal vias 21(1)-21(5) relating to the metal interconnects 20 are concurrently obtained.

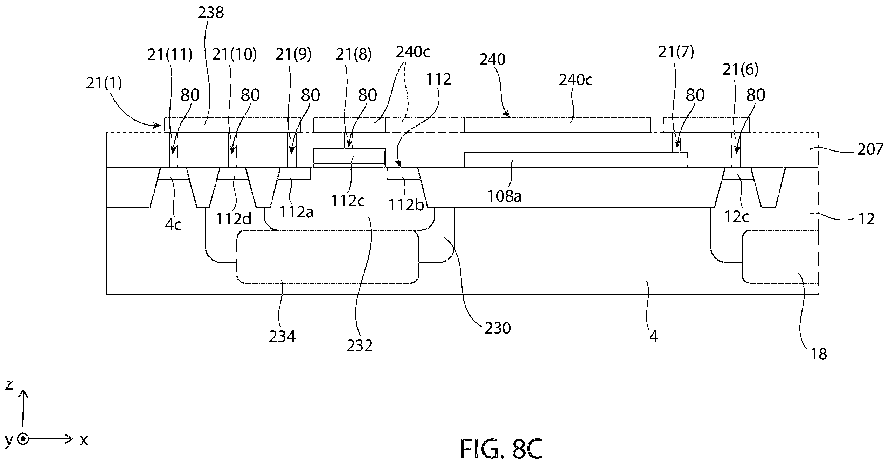

With reference to Figure 8C, deposition steps (e.g. sputtering) of metal material are performed to form the first metal layer 22(1), followed by patterning steps (e.g. lithography and etching or lift-off), thus forming the metal connections 101, 103, 105, 109, 111 and the second plate 108b of the capacitor 108. It should be noted that during these steps the metal connection 107 illustrated for example in Figure 4B is also formed. Following these steps, the capacitor 250 is capable of operating and the HV-NMOS transistor 112 is activatable as described with reference to Figure 2A for the protection of the integrated circuit 100. Similarly, the HV-NMOS transistor 112 is activatable following these steps in embodiments wherein the capacitor 400 is used in the place of the capacitor 250, and/or wherein the source-gate coupling capacitor 702 is present.

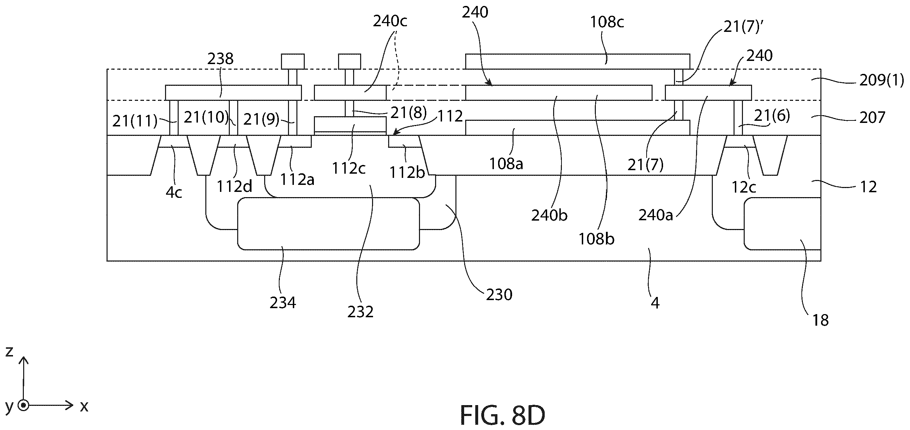

With reference to Figure 8D, process steps similar to those described in reference to Figures 8A-8C are performed to form and pattern respectively and in a manner known per se: the first inter-metal dielectric layer 209(1), respective metal vias 21(1)'-21(L)' and the second metal layer 22(2). It should be noted that following this step the third plate 108c of the capacitor 250 is formed, which provides capacitive coupling between the gate terminal 112c and the node 104, thus improving the response of the HV-NMOS transistor 112 to variations in the voltage drop V_{D}. It should be noted that in these steps the HV-NMOS transistor 112 is activatable as described with reference to Figure 2A for the protection of the integrated circuit 100.

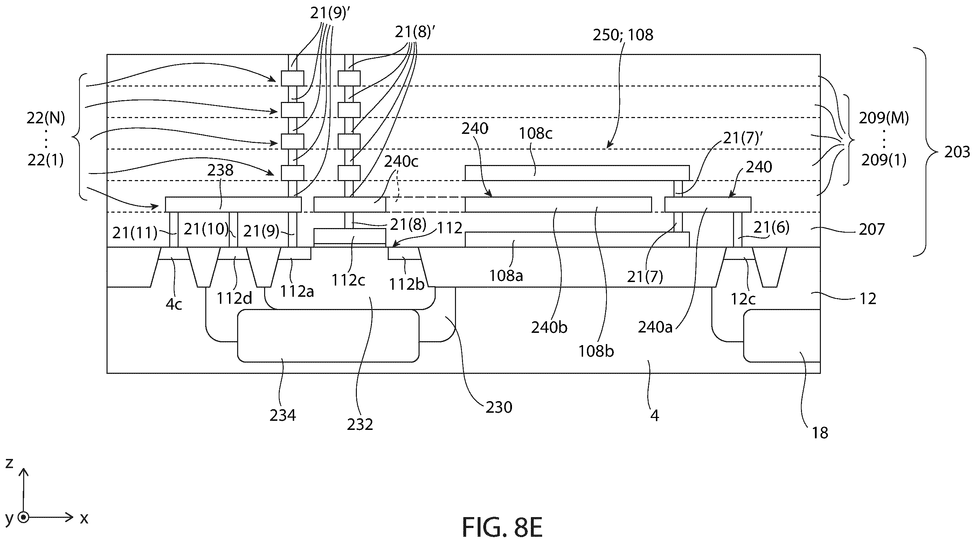

With reference to Figure 8E, process steps similar to those described in reference to Figures 8A-8C are performed recursively to form and pattern respectively and in a manner known per se the inter-metal dielectric layers 209(2)-209(M), respective metal vias 21(1)'-21(L)' and the metal layers 222(3)-22(N-1), up to obtaining the structure described in reference to Figure 4C. It should be noted that in these steps the HV-NMOS transistor 112 is activatable as described with reference to Figure 2A for the protection of the integrated circuit 100.

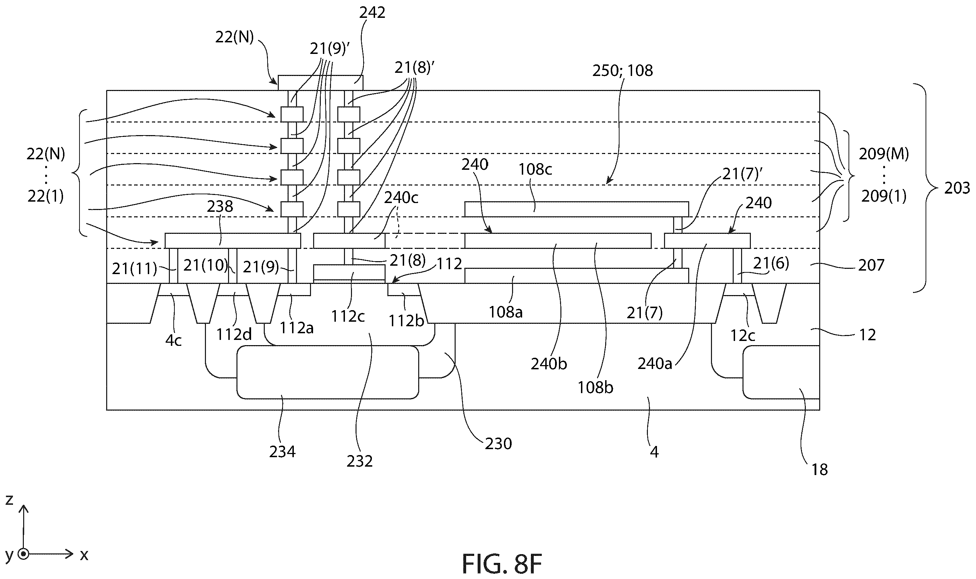

With reference to Figure 8F, process steps similar to those described with reference to Figure 8C are performed to form the portion 242 of the last metal layer 22(N), thus forming the seventh metal connection 113. It should be noted that in these steps, and following them, the HV-NMOS transistor 112 is no longer activatable, as described with reference to Figure 2B.

Optionally, a deposition step of passivating or insulating material (e.g., SiN) is also performed above the dielectric stack 203 and the last metal layer 22(N), for protection and electrical insulation of the same. Electrical contact regions are formed through the passivating layer for biasing the integrated circuit 100, in a manner known per se.

Finally, it is clear that modifications and variations may be made to what has been described and illustrated herein without thereby departing from the scope of the present invention, as defined in the attached claims.

In the light of what has been previously exposed, the advantages that the present invention affords are evident.

In particular, it is noted that the protection circuit 50 or 51 ensures protection from plasma-induced damages due to the charging of doped regions during the manufacturing processes of the integrated circuit 100 or 700, without the need to apply external biasing voltages by voltage generators dedicated to this purpose. Such external biasing voltages are not necessary either to keep the HV-NMOS transistor 112 activatable during the process steps described with reference to Figures 8C-8E, or to deactivate it following the steps described with reference to Figure 8F, and in particular during the life cycle of the integrated circuit 100 or 700. In this manner, protection from plasma-induced damages is achieved through a reduced occupation of circuit area, with the use of a single transistor, one (protection circuit 50) or two (protection circuit 51) capacitors and the respective interconnects.

Furthermore, the capacitive coupling between the gate terminal 112c and the node 104 to be discharged allows, during the process steps described with reference to Figures 8C-8E, the HV-NMOS transistor 112 to be controlled with a voltage drop V_{GS} that directly depends on the potential of the node 104. The HV-NMOS transistor 112, the capacitor 108 (in one of its implementations described) and, where present, the capacitor 702, are appropriately sized depending on the architecture of the integrated circuit 100 or 700 to be protected, to ensure the correct turn-on and the correct turn-off of the HV-NMOS transistor 112.

It should also be noted that the protection circuit 50 or 51, being connected to the node 104 to be discharged rather than to a node to be protected, simultaneously ensures the protection of all the circuit elements connected to said node 104 and which might suffer damages due to the plasma-induced charging.

Finally, it should be noted that the protection circuit 50 or 51, although described herein in connection with only one embodiment of the first circuit block 6 and the second circuit block 8, is applicable whenever a MOS device located within a first circuit block has a gate terminal driven by a second circuit block, and one of the first circuit block and the second circuit block is connected to multiple metal interconnects acting as an antenna with respect to the other of the first circuit block and the second circuit block, both circuit blocks being insulated from a substrate by respective Deep N-WELLs. In other words, the protection circuit 50 or 51 finds application whenever accumulations of positive charges are generated within a circuit block during plasma processes due to the so-called "antenna effect", and there is a need to disperse such charges.

## Claims

1. An electronic device (100; 700), comprising:
- a circuit module (6); and
- a protection module (50; 51),
the circuit module (6) comprising: a P-N junction (102) electrically coupled between a reference terminal (GND) and an electrical node (104); and a plurality of metal connection lines (20) electrically coupled to the electrical node (104) and adapted to be charged by positive electrical charges due to antenna effect when subject to a plasma treatment;
the protection module (50; 51) comprising: a first transistor (112) having an N-channel, having a first (112a) and a second (112b) conduction terminal and a control terminal (112c); and capacitive means (108; 114; C_{GD}),
wherein the second conduction terminal (112b) of the first transistor (112) is electrically coupled to the electrical node (104), the first conduction terminal (112a) of the first transistor (112) is electrically coupled to the reference terminal (GND),
and wherein the control terminal (112c) of the first transistor (112) is capacitively coupled to the electrical node (104) through said capacitive means (108; 114; C_{GD}).

2. The electronic device according to claim 1, wherein said capacitive means (108; 114; C_{GD}) include:
a first capacitor (108); alternatively
a connection in electric parallel (114) between a first capacitor (108) and an intrinsic capacitance (C_{GD}) of the first transistor (112), said intrinsic capacitance (C_{GD}) being between the control terminal (112c) and the second conduction terminal (112b).

3. The electronic device according to claim 1 or 2, wherein the first transistor (112) has a body terminal (112d) electrically connected to the first conduction terminal (112a) and to the reference terminal (GND).

4. The electronic device according to any of the preceding claims, wherein the control terminal (112c) of the first transistor (112) is electrically coupled to the first conduction terminal (112a) of the first transistor (112).

5. The electronic device according to claim 4, wherein the control terminal (112c) of the first transistor (112) is:
i) directly electrically connected to the first conduction terminal (112a) of the first transistor (112);
alternatively:
ii) electrically coupled to the first conduction terminal (112a) of the first transistor (112) by a second capacitor (702).

6. The electronic device according to any of the preceding claims, wherein the first transistor (112) has a threshold voltage comprised between 0.5 and 3V, the capacitive means (108; 114; C_{GD}) have a specific capacitance with a value comprised between 0.01 fF/µm² and 4.0 fF/µm².

7. The electronic device according to any of the preceding claims, further comprising a solid body (4) having a surface (4a) and a dielectric layer (3; 203) extending on the surface (4a) of the solid body (4),
said metal connection lines (20) being formed in said dielectric layer (3; 203) and comprising: a lower connection line (22(1)), an upper connection line (22(N)) above the lower connection line (22(1)), and at least one intermediate connection line (22(2); ...; 22(N-1)) between the lower connection line and the upper connection line,
wherein the lower connection line (22(1)) is, among said metal connection lines (20), the closest to the surface (4a) of the solid body (4), and the upper connection line (22(N)) is, among said metal connection lines (20), the farthest from the surface (4a) of the solid body (4),
wherein the control terminal (112c) of the first transistor (112) is electrically coupled to the first conduction terminal (112a) of the first transistor (112) by an electrical connection (113) extending at least in part coplanar to the upper connection line (22(N)) or extending at least in part above the upper connection line (22(N)).

8. The electronic device according to claim 7, wherein the solid body (4) is of semiconductor material having P-type electrical conductivity and forms said reference terminal (GND),
the electronic device further comprising:
- a first doped region (12) in the solid body (4), facing the surface (4a), of the N type and having a first doping value;
- a second doped region (18) buried in the solid body (4), of the N-type and having a second doping value greater than the first doping value, wherein the second doped region (18) extends between part of the first doped region (12) and the solid body (4), in direct electrical contact with the first doped region (12) and with the solid body (4),
said P-N junction (102) being formed at the interface between the first and the second doped regions (12, 18) and the solid body (4).

9. The electronic device according to claim 8, wherein said first doped region (12) accommodates at least one second transistor (10; 14), said metal connection lines (20) being coupled to conduction terminals of said second transistor (10; 14).

10. The electronic device according to claims 2, wherein, when said capacitive means include said first capacitor, the first capacitor (108, 250) comprises a first conductive plate (108a), a second conductive plate (108b) and a third conductive plate (108c),
the first conductive plate (108a) extending between the surface (4a) of the substrate (4) and the lower connection line (22(1)), the second conductive plate (108b) extending coplanar to the lower connection line (22(1)), and the third conductive plate (108c) extending above the lower connection line (22(1)) and directly faces the second conductive plate (108b) through a respective portion of the dielectric layer (3; 203),
wherein the first conductive plate (108a) and the third conductive plate (108c) are electrically connected to the electrical node (104), and the second conductive plate (108b) is electrically connected to the control terminal (112c) of the first transistor (112).

11. The electronic device according to claims 2, wherein, when said capacitive means include said first capacitor, the first capacitor (108, 400) is of the Metal-Oxide-Metal, MOM, type and has a structure with interdigitated electrodes coplanar to the lower connection line (22(1)) and electrically connected respectively to the electrical node (104) and to the control terminal (112c) of the first transistor (112).

12. The electronic device according to claims 2, wherein, when said capacitive means include said first capacitor, the first capacitor (108, 300) comprises a first conductive plate (302) and a second conductive plate (304),
the first conductive plate (302) extending between the surface (4a) of the substrate (4) and the lower connection line (22(1)), and the second conductive plate (304) extending above the lower connection line (22(1)) and directly facing the first conductive plate (302) through a respective portion of the dielectric layer (3; 203) having a thickness (tₒₓ) greater than 100nm,
wherein the first conductive plate (302) is electrically connected to the electrical node (104) and the second conductive plate (304) is electrically connected to the control terminal (112c) of the first transistor (112).

13. A method of manufacturing an electronic device (100; 700), comprising the steps of:
- forming a circuit module (6); and
- forming a protection module (50; 51),
wherein forming the circuit module (6) comprises: forming a P-N junction (102) electrically coupled between a reference terminal (GND) and an electrical node (104); and forming, by one or more plasma-assisted processes, a plurality of metal connection lines (20) electrically coupled to the electrical node (104) and adapted to be charged by positive electrical charges due to antenna effect when subject to said one or more plasma-assisted processes;
and wherein forming the protection module (50; 51) comprises: forming a first transistor (112) having an N-channel, having a first (112a) and a second (112b) conduction terminal and a control terminal (112c); and forming capacitive means (108; 114; C_{GD}),
wherein the second conduction terminal (112b) of the first transistor (112) is electrically coupled to the electrical node (104), the first conduction terminal (112a) of the first transistor (112) is electrically coupled to the reference terminal (GND), and said capacitive means (108; 114; C_{GD}) are formed between the control terminal (112c) of the first transistor (112) and the electrical node (104) to electrically couple the control terminal (112c) to the electrical node (104).

14. The method according to claim 13, further comprising the step of electrically coupling the control terminal (112c) of the first transistor (112) to the first conduction terminal (112a) of the first transistor (112).

15. The method according to claim 14, wherein the step of forming the plurality of metal connection lines (20) ends with the formation of an upper metal line (22(N)),
the step of electrically coupling the control terminal (112c) of the first transistor (112) to the first conduction terminal (112a) comprising forming an electrical connection (113) concurrently with the formation of the upper metal line (22(N)).

16. The method according to any of claims 13-15, further comprising the steps of:
i) directly connecting the control terminal (112c) to the first conduction terminal (112a) of the first transistor (112);
alternatively:
ii) electrically coupling the control terminal (112c) to the first conduction terminal (112a) of the first transistor (112) by a second capacitor (702).
